# EUROPÄISCHE PATENTSCHRIFT

(11) **EP 1 129 233 B1**
(45) Veröffentlichungstag und Bekanntmachung des Hinweises auf die Patenterteilung: **26.06.2002**
(21) Anmeldenummer: 99946188.2
(22) Anmeldetag: 18.09.1999
(51) Int. Cl.: C23C 16/02

(54) **VERFAHREN ZUR DIAMANT-BESCHICHTUNG VON OBERFLÄCHEN**
METHOD FOR DIAMOND-COATING SURFACES
PROCEDE D'APPLICATION DE REVETEMENT DE DIAMANT SUR DES SURFACES

(30) Priorität: 29.09.1998 DE 19844538
(43) Veröffentlichungstag der Anmeldung: 05.09.2001
(73) Patentinhaber: FRAUNHOFER-GESELLSCHAFT ZUR FÖRDERUNG DER ANGEWANDTEN FORSCHUNG E.V., 80636 München (DE)
(72) Erfinder: KOIDL, Peter, D-79211 Denzlingen (DE); WILD, Christoph, D-79211 Denzlingen (DE); MANGANG, Pascal, D-79211 Denzlingen (DE)
(74) Vertreter: Maucher, Wolfgang, Dipl.-Ing.
(86) Internationale Anmeldenummer: EP9906928
(87) Internationale Veröffentlichungsnummer: WO0018981

(56) Entgegenhaltungen:
- DE-A- 4 235 015
- GB-A- 2 240 114
- YUGO S ET AL: "GENERATION OF DIAMOND NUCLEI BY ELECTRIC FIELD IN PLASMA CHEMICAL VAPOR DEPOSITION" APPLIED PHYSICS LETTERS,US,AMERICAN INSTITUTE OF PHYSICS. NEW YORK, Bd. 58, Nr. 10, Seite 1036-1038 XP000222923 ISSN: 0003-6951 in der Anmeldung erwähnt
- PATENT ABSTRACTS OF JAPAN vol. 1998, no. 10, 31. August 1998 (1998-08-31) & JP 10 121246 A (SEMICONDUCTOR ENERGY LAB CO LTD), 12. Mai 1998 (1998-05-12)

## Beschreibung

Die Erfindung bezieht sich auf ein Verfahren zur Beschichtung von Oberflächen mit Diamant aus der Gasphase.
Die Abscheidung von Diamant aus der Gasphase (englisch: chemical vapour deposition - CVD) erfordert die Bildung von Diamantkeimen auf der zu beschichtenden Oberfläche. Je größer die Keimdichte ist, desto früher bildet sich eine geschlossene Diamantschicht und desto homogener ist das Korngefüge. Empirisch hat sich gezeigt, daß sich die Keimdichte durchmechanische Vorbehandlungsverfahren, wie beispielsweise Politur mit Diamantpulver, Ultraschallbehandlung in einer Suspension aus Diamantpulver und Alkohol und dergleichen, erhöhen läßt. Diese mechanischen Verfahren haben jedoch den Nachteil, daß die so behandelte Substratoberfläche beschädigt beziehungsweise verkratzt wird. Weiterhin ist es aus "Generation of Diamond Nuclei by Electric Field in Plasma Chemical Vapour Deposition" S.Yugo, T. Kanai, T. Kimura and T. Muto; Applied Physics Letters 58, 1036 (1991) bekannt, daß in einem Mikrowellen-Plasma in einer Methan/Wasserstoff-Atmosphäre durch Anlegen einer negativen Spannung an das Substrat die Bildung von Diamantkeimen begünstigt wird (englisch: bias enhanced nucleation - BEN).
Nachteilig ist bei diesem BEN-Verfahren, daß es sich wegen der räumlichen Begrenzung der Mikrowellenentladung nicht auf große Flächen skalieren läßt und sich nicht für die Bekeimung elektrisch isolierender Substrate eignet, weil dieses Verfahren das Fließen eines Gleichstromes durch das Substrat erfordert.

Aus der GB-A-2 240 114 ist ein Nukleationsprozess für die Diamantabscheidung auf Infrarotmaterialien, wie ZnS bekannt, auf denen ohne Zwischenschicht kein Diamant abgeschieden werden kann. Dabei wird zunächst in einer gepulsten, induktiven Hohlkathoden-Entladung eine multiphasige Kohlenstoffschicht abgeschieden, die in einem zweiten Schritt in einer Atmosphäre von atomarem Wasserstoff selektiv geätzt wird. Es ist somit ein zweistufiger Abscheide-/Ätzprozess erforderlich.
Die Behandlung erfolgt dabei unter Verwendung von reinem CH₄ und einer positiven Bias-Spannung am Substrat, die zum Beschuss des Substrates mit negativen Ionen führt.

Aufgabe der vorliegenden Erfindung ist es, ein Verfahren der eingangs erwähnten Art zu schaffen, das zur Erzielung hoher Nukleationsdichten geeignet ist und bei dem nur eine minimale Schädigung der Substratoberfläche eintritt. Außerdem soll die Möglichkeit der Skalierung auf große Flächen vorhanden sein und schließlich sollen auch unregelmäßig beziehungsweise dreidimensionale Substratoberflächen behandelt werden können.

Zur Lösung dieser Aufgabe wird vorgeschlagen, daß die zu beschichtende Oberfläche eines wahlweise aus elektrisch isolierendem oder elektrisch leitendem Material bestehenden Substrates zunächst während einer Vorbehandlung in einer Atmosphäre aus Wasserstoff und einem Kohlenwasserstoff bei erhöhter Temperatur von etwa 600 °C bis etwa 800 °C und bei einem Druck der das Substrat umgebenden Atmosphäre von kleiner als 10 mbar, in einer kapazitiven Hochfrequenz-Entladung durch Ionenbeschuß vorbehandelt wird und daß dann die Beschichtung durch Abscheidung von Diamant aus der Gasphase erfolgt.
Versuche haben gezeigt, daß bei einer anschließenden Mikrowellen-CVD-Abscheidung ein Diamantwachstum erreicht wird, bei dem überraschenderweise schon innerhalb kürzester Zeit ein Schichtwachstum einsetzte. Dies ist darauf zurückzuführen, daß durch die erfindungsgemäße Vorbehandlung eine sehr hohe Diamantkeimdichte erzielt wurde. Genaue Untersuchungen haben gezeigt, daß während der Vorbehandlung eine mikrokristalline, etwa 15 Angström dicke Graphitschicht abgeschieden wird und die Oberfläche selbst in ihrer Kristallstruktur geändert wird.
Besonders vorteilhaft ist auch, daß auch ein Bekeimen von isolierenden Substraten möglich ist. Weiterhin ist vorteilhaft, daß Hochfrequenzentladungen sehr großflächig realisiert werden können, so daß mit diesem Verfahren eine großflächige Bekeimungsmethode zur Verfügung steht. Die nachfolgende Diamant-CVD kann dann entweder durch Mikrowellen-Plasma-CVD oder Hot-Filament-CVD realisiert werden. Auch hierfür stehen großflächige CVD-Verfahren zur Verfügung.

Ausgestaltungen der Erfindung sind in den Unteransprüchen wiedergegeben. Nachstehend ist die Erfindung mit ihren wesentlichen Einzelheiten anhand der Zeichnungen noch näher beschrieben.

Es zeigt:
- Fig.1: eine Längsschnittdarstellung einer Vorrichtung zur Behandlung von Substratoberflächen,
- Fig.2: ein Diagramm, bei dem über der Hochfrequenz-Vorbehandlungszeit die Keimdichte auf einem Siliziumsubstrat aufgetragen ist, und
- Fig.3: ein etwa Fig.2 entsprechendes Diagramm, hier jedoch für die Behandlung eines nichtleitenden Saphirsubstrats.

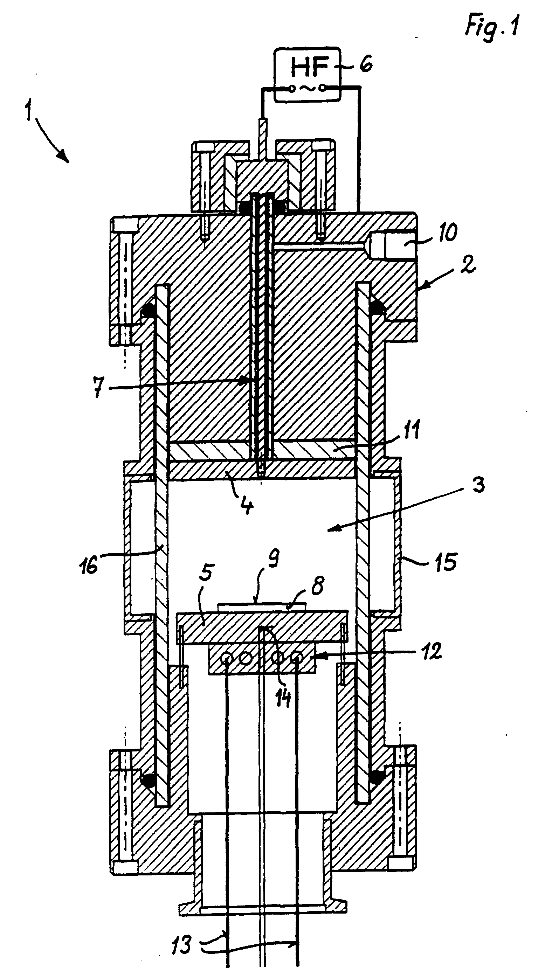

Eine in Fig.1 gezeigte Vorrichtung 1 dient zur Behandlung von Substratoberflächen, insbesondere zur Vorbehandlung der Substratoberfläche für eine anschließende Beschichtung mit Diamant aus der Gasphase. Sie weist ein dichtes Reaktorgehäuse 2 auf, in dem sich eine Behandlungskammer 3 befindet. In dieser sind zwei plattenförmige, mit ihrer Plattenebene etwa horizontal verlaufende Elektroden 4,5 angeordnet und mit einer Hochfrequenzquelle 6 verbunden. Die elektrische Zuleitung zu der unteren Elektrode 5 erfolgt über das Reaktorgehäuse 2, während für die obere Elektrode 4 eine Koaxialzuführung 7 mit einem Innenleiter und einer diese umgebenden Isolierung vorgesehen ist.
Die Elektrode 4 ist gegen das Gehäuse durch eine Isolierung 11 elektrisch isoliert. Die Behandlungskammer 3 ist durch ein Quarzrohr 16 abgedichtet.
Die untere Elektrode 5 dient zur Auflage eines Substrats 8, dessen Oberfläche 9 vorbehandelt und anschließend mit Diamant aus der Gasphase beschichtet werden soll.
Unterhalb der Elektrode 5 ist eine Heizung 12 angeordnet, die im vorliegenden Fall als elektrische Heizung mit entsprechenden Stromzuführungen 13 ausgebildet ist, um mittelbar über die Elektrode 5 das Substrat 8 erwärmen zu können. Die Heizung 12 ist so ausgelegt, daß sich Substrattemperaturen von beispielsweise 800° Celcius einstellen lassen. Für eine geregelte Temperierung ist ein vorzugsweise durch ein Thermoelement gebildeter Temperaturfühler 14 vorzugsweise innerhalb der Elektrode 5 vorgesehen.

Für die Abscheidung von Diamant aus der Gasphase wird zu der Behandlungskammer 3 über einen Hohlleiter 1 5 Mikrowellen-Energie im Anschluß an die Vorbehandlung des Substrates 8 zugeführt. Die Mikrowellenfrequenz kann beispielsweise 2,45 GHz bei einer Leistung von 600 Watt und einer Substrattemperatur von 750° Celcius betragen. Die das Substrat umgebende Atmosphäre besteht dabei aus etwa 3 Prozent Methan in Wasserstoff bei einem Druck von 55 mbar.
Die Vorbehandlung der Substrat-Oberfläche 9 soll die Bildung von Diamantkeimen begünstigen, wobei eine möglichst hohe Nukleationsdichte angestrebt ist. Um dies zu erreichen, wird die zu beschichtende Oberfläche 9 zunächst in einer Atmosphäre aus Wasserstoff und einem Kohlenwasserstoff bei erhöhter Temperatur in einer Hochfrequenz-Entladung zwischen den beiden Elektroden 4 4 und 5 vorbehandelt. Die Gaszuführung erfolgt über einen Gaseinlaß 10 und einen in der Schnittdarstellung nicht erkennbaren Zuführkanal zu der Behandlungskammer 3. Die das Substrat 8 umgebende Atmosphäre während der Vorbehandlung besteht aus etwa 10 bis 80 Prozent vorzugsweise aus etwa 40 Prozent Methan in Wasserstoff.
Während der Hochfrequenzvorbehandlung erfolgt ein kontinuierlicher Ionenbeschuß der Substratoberfläche mit dem Ergebnis, daß die Substratoberfläche mit einer microkristallinen Graphitschicht bedeckt ist und die Oberfläche selbst eine Änderung ihrer Kristallstruktur erfährt.
Diese Vorbehandlung führt dazu, daß in Abhängigkeit der Vorbehandlungszeit bei einer anschließenden Beschichtung mit Diamant aus der Gasphase eine vergleichsweise hohe Keimdichte erzielt wird. Die Anzahl der Keime bei der Beschichtung ist somit von der Vorbehandlung und dabei insbesondere der Vorbehandlungszeit ab-hängig.

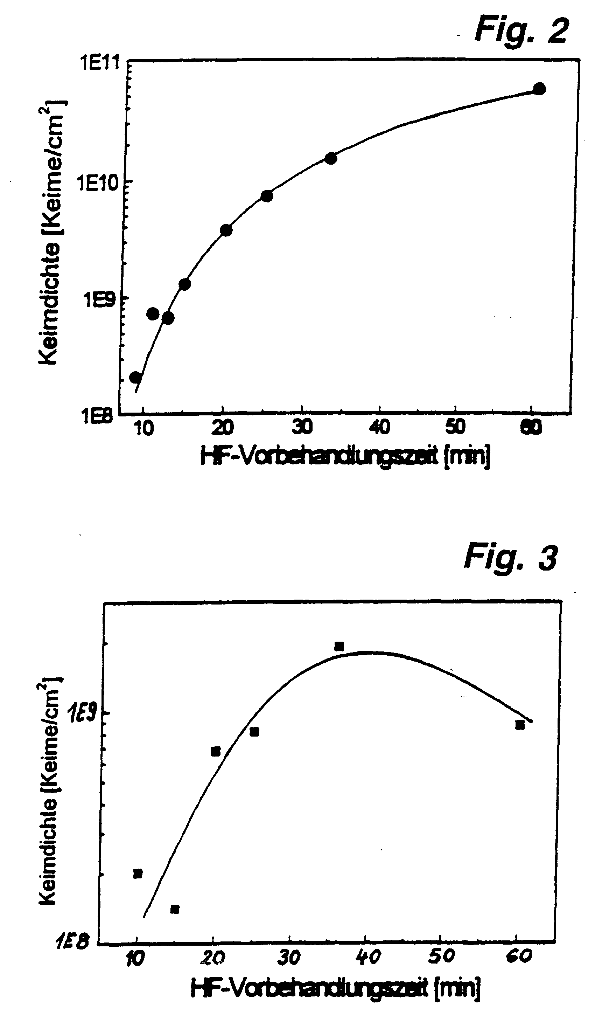

Fig.2 zeigt eine solche Abhängigkeit, wobei auf der Abszisse die Hochfrequenz-Vorbehandlungszeit in Minuten und auf der Ordinate die Keimdichte pro Quadratzentimeter aufgetragen sind. Die Vorbehandlung lief dabei in einer Atmosphäre aus 33 Prozent Methan und 67 Prozent Wasserstoff bei einem Druck 1,6 mbar ab. Die Frequenz betrug dabei 13,56 MHz bei einer Leistung von 16 Watt. Bei diesem Versuch wurde ein Silicium-Substrat verwendet, das auf eine Temperatur von etwa 800° Celcius erwärmt wurde.
Diese Vorbehandlung führt zu einer Modifikation der Substrat-Oberfläche, welche bei einer anschließenden Diamant-CVD die Bildung von Diamantkeimen begünstigt. Wie aus dem Diagramm ersichtlich, lassen sich bereits nach einer Vorbehandlungszeit von 30 Minuten Keimdichten oberhalb von 10¹⁰cm⁻² erreichen. An den sich bildenden Nukleationskeimen wachsen dann die Diamantkristalle, so daß sich schließlich eine zusammenhängende Schicht aus der vorgegebenen Anzahl von Keimen bildet.
Die Vorbehandlung mit Hilfe des Hochfrequenzfeldes und die Beschichtung der Substratoberfläche mit Diamant aus der Gasphase erfolgen zeitlich nacheinander. Im vorliegenden Ausführungsbeispiel ist für beide Prozesse eine gemeinsame Vorrichtung vorgesehen, es besteht aber auch die Möglichkeit, die Vorbehandlung mit dem Hochfrequenzfeld und die Diamant-CVD in unterschiedlichen Vorrichtungen durchzuführen. Dies ist insbesondere dann zweckmäßig, wenn großflächige Substrate vorbehandelt und anschließend beschich-tet werden sollen. In diesem Fall kann einerseits eine Apparatur für eine großflächige Hochfrequenzentladung für die Vorbehandlung vorgesehen sein und die Beschichtung solcher großflächiger Substrate kann beispielsweise durch eine sogenannte Hot-Filament-CVD reali-siert werden. Mit dem anhand des Diagrammes gem Fig. 1 beschriebenen Vorbehandlungsverfahren können auf einkristallinen Silicium- und Siliciumcarbid-Substraten auch heteroepitaktisch orientierte Diamantkeime gebildet werden, wenn die Vorbehandlungsdauer und die Parameter des nachfolgenden Diamant-CVD-Prozesses entsprechend modifiziert werden.
Nach einer Vorbehandlung wie gemäß Fig.2 beschrieben, kann eine solche epitaktische Diamantbildung durch Mikrowellen-Plasma-CVD realisiert werden, wenn bei einer Frequenz von 2,45 GHz, einer Leistung von 600 Watt, einer Substrattemperatur von 600° Celcius das Prozeßgas 1,5 Prozent Methan und 200 ppm Stickstoff in Wasserstoff bei 55 mbar Druck enthält. Untersuchungen haben gezeigt, daß bereits bei Vorbehandlungsdauern von etwa 10 Minuten ein epitaktischer Orientierungszusammenhang zwischen Diamantschicht und Silicium-Substrat vorliegt. Der epitaktische Ordnungsgrad der Diamantschicht sinkt mit zunehmender Vorbehandlungsdauer. Eine epitaktische Vorzugsorientierung der Diamantschicht relativ zum Silicium-Substrat ist bei Vorbehandlungsdauern bis etwa 60 Minuten vorhanden.
Die heteroepitaktische Diamantnukleation auf β-Siliciumcarbid wird in gleicher Weise realisiert. Auch hier zeigen Röntgenuntersuchungen eine heteroepitaktische Orientierung der Diamantschicht. Im Gegensatz zu Silicium bleibt die heteroepitaktische Orientierung der Diamantschicht bei Vorbehandlungsdauern zwischen 10 Minuten und 120 Minuten erhalten.

Fig.3 zeigt ein Diagramm, in dem die Keimdichte in Abhängigkeit der Hochfrequenz-Vorbehandlungszeit in Verbindung mit einem Saphir-Substrat aufgetragen ist. Das Saphir-Substrat liegt bei der Vorbehandlung auf der unteren Elektrode 5 auf und wird mit Hilfe der Heizung 12 auf eine Temperatur von etwa 800° Celcius erwärmt. Die Hochfrequenz-Entladung wird in einer Atmosphäre aus 33 Prozent Methan und 67 Prozent Wasserstoff bei einem Druck von 1,7 mbar gezündet, wobei die Frequenz 13,56 MHz beträgt bei einer Leistung von 28 Watt.
Diese Bedingungen führen zu einer Modifikation der Oberfläche des Saphir-Substrats welche bei einer anschließenden Diamant-CVD die Bildung von Diamantkeimen mit der von der Vorbehandlungszeit gem. Fig.3 abhängigen Keimdichte zur Folge hat. Es lassen sich hierbei Keimdichten von oberhalb 10⁹cm⁻² erreichen. In diesem Ausführungsbeispiel wurde die Diamantbildung durch Mikrowellen-Plasma-CVD bei 2,45 GHz, einer Leistung von 600 Watt, einer Substrattemperatur von 610° Celcius in einer Atmosphäre mit 1,5 Prozent Methan in Wasserstoff bei 5 mbar Druck und einer Dauer von 30 Minuten realisiert.
Somit können auch elektrisch isolierende Substrate wie beispielsweise Saphir oder Quarzglas so vorbehandelt werden, daß sich eine vergleichsweise hohe Substrat-Bekeimung bei der anschließenden Diamant-CVD einstellt.

Insgesamt zeichnet sich das erfindungsgemäße Verfahren durch folgende Eigenschaften aus:
- Erzielung hoher Nukleationsdichten
- minimale Schädigung der Substrat-Oberfläche
- Möglichkeit der Skalierung auf große Flächen, da Hochfrequenzfelder großflächig realisierbar sind
- Übertragbarkeit auf unregelmäßig geformte, dreidimensionale Oberflächen weil durch das Hochfrequenzfeld eine homogene Keimbildung möglich ist
- Eignung auch für elektrisch isolierende Substrate
- Erzeugung epitaktisch orientierter Keime auf großen Flächen.

## Patentansprüche

1. Verfahren zur Beschichtung von Oberflächen mit Diamant aus der Gasphase, **dadurch gekennzeichnet, daß** die zu beschichtende Oberfläche eines wahlweise aus elektrisch isolierendem oder elektrisch leitendem Material bestehenden Substrates zunächst während einer Vorbehandlung in einer Atmosphäre aus Wasserstoff und einem Kohlenwasserstoff bei erhöhter Temperatur von etwa 600 °C bis etwa 800 °C und bei einem Druck der das Substrat umgebenden Atmosphäre von kleiner als 10 mbar, in einer kapazitiven Hochfrequenz-Entladung durch Ionenbeschuß vorbehandelt wird und daß dann die Beschichtung durch Abscheidung von Diamant aus der Gasphase erfolgt.

2. Verfahren nach Anspruch 1, **dadurch gekennzeichnet, daß** die Hochfrequenz-Entladung in einer Atmosphäre aus etwa 10% bis 80%, vorzugsweise aus etwa 40% Methan in Wasserstoff betrieben wird.

3. Verfahren nach Anspruch 1 oder 2, **dadurch gekennzeichnet, daß** die Vorbehandlung bei einem Druck der das Substrat umgebenden Atmosphäre von 1 mbar bis 6 mbar vorgenommen wird.

4. Verfahren nach einem der Ansprüche 1 bis 3, **dadurch gekennzeichnet, daß** die Vorbehandlung der Oberfläche eines Substrates über einen Zeitabschnitt von wenigen Minuten bis etwa einer Stunde vorgenommen wird.

## Claims

1. A process for coating surfaces with diamond from the gaseous phase, **characterised in that** the surface which is to be coated of a substrate which selectively comprises electrically-insulating or electrically-conductive material is firstly pretreated by ion bombardment in a capacitative high-frequency discharge during preliminary treatment in an atmosphere of hydrogen and a hydrocarbon at increased temperature of approximately 600° C to approximately 800° C and with the pressure surrounding the substrate being less than 10 mbar, and that coating then takes place by separating diamond from the gaseous phase.

2. A process according to claim 1, **characterised in that** the high-frequency discharge is effected in an atmosphere of approximately 10% to 80%, preferably approximately 40%, methane in hydrogen.

3. A process according to claim 1 or 2, **characterised in that** preliminary treatment is carried out with the atmosphere surrounding the substrate having a pressure of 1 mbar to 6 mbar.

4. A process according to one of claims 1 to 3, **characterised in that** the preliminary treatment of the surface of a substrate is carried out over a time period of a few minutes to approximately one hour.

## Revendications

1. Procédé pour appliquer un revêtement de diamant sur des surfaces à partir de la phase gazeuse, **caractérisé en ce que** la surface à revêtir d'un substrat, composé au choix d'un matériau électriquement conducteur ou d'un matériau électriquement isolant, est d'abord prétraitée au cours d'un prétraitement sous une atmosphère constituée d'hydrogène et d'un hydrocarbure, à une température élevée comprise entre environ 600 °C et environ 800 °C et à une pression de l'atmosphère enveloppant le substrat inférieure à 10 mbar, par une décharge capacitive à haute fréquence à bombardement ionique, et **en ce qu'**ensuite est effectué le revêtement par séparation de diamant de la phase gazeuse.

2. Procédé selon la revendication 1, **caractérisé en ce que** la décharge à haute fréquence est réalisée dans une atmosphère constituée à environ 10 % à 80 %, de préférence à environ 40 % de méthane dans de l'hydrogène.

3. Procédé selon la revendication 1 ou 2, **caractérisé en ce que** le prétraitement est réalisé à une pression de l'atmosphère enveloppant le substrat comprise entre 1 mbar et 6 mbar.

4. Procédé selon l'une des revendications 1 à 3, **caractérisé en ce que** le prétraitement de la surface d'un substrat est réalisé sur une période allant de quelques minutes à environ une heure.
